# EUROPÄISCHE PATENTSCHRIFT

(11) **EP 0 379 004 B1**
(45) Veröffentlichungstag und Bekanntmachung des Hinweises auf die Patenterteilung: **25.08.1993**
(21) Anmeldenummer: 90100176.8
(22) Anmeldetag: 05.01.1990
(51) Int. Cl.: H01L 31/18

(54) **Verfahren und Vorrichtung zur Herstellung eines Halbleiter-Schichtsystems**
Process and apparatus for the production of a semiconductor layer system
Procédé et dispositif pour la fabrication d'un système à couches semi-conductrices

(30) Priorität: 14.01.1989 DE 3901042
(43) Veröffentlichungstag der Anmeldung: 25.07.1990
(73) Patentinhaber: Nukem GmbH, D-63434 Hanau (DE)
(72) Erfinder: von Campe, Hilmar, Dr., D-6380 Bad Homburg (DE)
(74) Vertreter: Stoffregen, Hans-Herbert, Dr. Dipl.-Phys.

(56) Entgegenhaltungen:
- DE-A- 3 329 923
- DE-A- 3 342 046
- US-A- 4 571 448
- US-A- 4 778 478
- 15th IEEE Photovoltaic specialists conference 12 Mai 1981, KISSIMMEE, FLORIDA, USA Seiten 934 - 940; S.B.SCHULDT ET AL.: "LARGE-AREA SILICON-ON-CERAMIC SUBSTRATES FOR LOW-COST SOLAR CELLS"
- 14TH IEEE PHOTOVOLTAIC SPECIALISTS CONFERENCE 07 Januar 1980, SAN DIEGO, CALIFORNIA, USA Seiten 39 - 48; J.D. HEAPS ET AL.: "CONTINUOUS COATING OF SILICON-ON-CERAMIC"
- JAPANESE JOURNAL OF APPLIED PHYSICS. vol. 19, no. 19-2, 1980, TOKYO JP Seiten 37 - 41; K.ITO ET AL.: "SOLUTION-GROWN SILICON SOLAR CELLS"

## Beschreibung

Die Erfindung bezieht sich auf ein Verfahren zur Herstellung eines Halbleiter-Schichtsystems für insbesondere großflächige photovoltaische Bauelemente, wobei zumindest eine Halbleiterschicht auf einer Trägerschicht dadurch aufgebracht wird, daß die Trägerschicht mit einer gelöstes Halbleitermaterial mit gegebenenfalls gewünschten Dotierstoffen aufweisenden Metallschmelze in Berührung gebracht wird und daß durch Erzeugung eines Gradienten wie Temperaturgradienten zwischen der Schmelze und der Trägerschicht das Halbleitermaterial mit den gegebenenfalls vorhandenen Dotierstoffen auf der Trägerschicht abgeschieden wird. Ferner bezieht sich die Erfindung auf eine Vorrichtung insbesondere zur Durchführung des Verfahrens.

Die Herstellungskosten für großflächige Halbleiteranordnungen wie z.B. Solarzellen, Festkörperbildschirme bzw. flache LCD-Bildschirme, die mit Transistoren angesteuert werden, nehmen mit wachsender Fläche zu. Dies gilt insbesondere in bezug auf die photovoltaische Energiegewinnung. Ursächlich hierfür ist der Bedarf großer Flächen, um Sonnenlicht in elektrische Energie umzuwandeln. Zu etwa einem Drittel der Gesamtherstellungskosten eines Solarzellen-Moduls tragen die Aufwendungen für die Herstellung des Basismaterials Silizium bei. Dieses muß, um einen vertretbaren Wirkungsgrad zu erzielen, durch energie- und kostenintensive Verfahrensabläufe die erforderliche Reinheit erhalten.

Eine Kostenreduzierung kann dadurch erfolgen, daß Dünnschichtbauelemente wie Dünnschichtsolarzellen oder -transistoren zum Einsatz gelangen, da durch den geringeren Bedarf an Halbleitermaterial die Kosten gesenkt werden können. Letztere werden auch durch den Herstellungsprozeß bestimmt, wobei Kriterien wie Materialausbeute bei der Abscheidung, Schichtdicke oder Wirkungsgrad der Solarzelle mitentscheidend sind, welche Technologie zum Einsatz gelangt.

Bei amorphem Silizium besteht der Vorteil, daß neben geringer Schichtdicke eine einfache Abscheidung auf großen Flächen bei niedrigen Abscheidetemperaturen möglich ist. Diesem stehen die Nachteile eines hohen Preises für das Ausgangsgas Silan, eines relativ niedrigen Wirkungsgrades auf großen Flächen und einer schlechten Langzeitstabilität der Bauelemente gegenüber. Dünne polykristalline Siliziumschichten zur Verwendung von Solarzellen können durch CVD-Abscheidung oder z.B. durch Vakuumverdampfung von Silizium hergestellt werden. Auch sind Versuche zur Rekristallisation von Siliziumschichten durch Tempern oder durch Aufschmelzen einer Siliziumschicht bekannt.

Solarzellen, die nach dem CVD-Verfahren hergestellt wurden, ergaben Wirkungsgrade von über 9% dann, wenn die Schichten auf Siliziumsubstraten (metallurgisches Si) abgeschieden wurde. Auf anderen Substraten konnten nur schlechtere Wirkungsgrade erzielt werden. Solarzellen, die durch Vakuum-Aufdampfverfahren hergestellt worden sind, zeigten Wirkungsgrade von in etwa 1 - 3%. Als Ursache dieses geringen Wirkungsgrades wird eine erhöhte Rekombinationsgeschwindigkeit der durch das Licht erzeugten Minoritätsladungsträger an den Korngrenzen verantwortlich gemacht. Daher verringert sich der Photostrom. Weitere Ursachen mögen Verunreinigungen sein, die bei den hohen Abscheidetemperaturen von über 1000°C aus dem Substrat in die Schicht diffundieren,
sich an den Korngrenzen anlagern und somit die freie Lebensdauer der Ladungsträger verschlechtern. Eine Erniedrigung der Substrattemperatur bewirkt jedoch das Wachstum von Schichten mit stark gestörtem Kristallgitter und kleineren Korndurchmessern.

Der US-PS 4,571,448 ist ein Verfahren zur Herstellung von photovoltaischen Schichten zu entnehmen, bei dem polykristalline Si-Schichten durch Abscheiden aus einer Zinnschmelze hergestellt werden. Hierbei wird die "sliding boat technique" benutzt, bei der das Trägersubstrat unter einer Graphithalterung mit Aussparungen, die die Lösung von Si in Sn enthalten, hindurchgezogen wird. Die Abscheidung selbst erfolgt vorzugsweise aufgrund eines zwischen der Schmelze und dem Substratträger vorhandenen Temperaturgradienten.

Da die Schmelze oberhalb des Substratträgers vorliegt, sind der Größe der abzuscheidenden Flächen Grenzen gesetzt, da andernfalls das Gewicht der Schmelzlösung zu einer Störung, gegebenenfalls Verbiegung oder Bruch des Substratträgers führen könnte. Dadurch muß die Höhe der Schmelze über dem Substrat bei großen Flächen begrenzt werden, wodurch eine gleichmäßige Verteilung des gelösten Stoffes erschwert wird, was zu unterschiedlichen Abscheideraten führt. Außerdem ändert sich die Konzentration des gelösten Stoffes in der Schmelze ziemlich schnell, so daß eine Nachfüllung nötig wird, was für den kontinuierlichen Betrieb von Nachteil ist. Ebenso reichern sich Verunreinigungen aus dem Substrat in der Schmelze schnell an, so daß ein Nachfüllen und Erneuerung der Schmelze im kontinuierlichen Betrieb nötig ist. Schließlich ist ein Nachfüllen von Schmelze mit dem Nachteil verbunden, daß im Bereich des Substratträgers Erschütterungen oder Turbulenzen auftreten können, wodurch wiederum die Qualität der Halbleiterschicht negativ beeinflußt wird.

Der DE-OS 36 05 973 ist eine Flüssigphasen-Epitaxieanordnung zu entnehmen, bei der zu beschichtende Halbleiter-Substrate unter Schmelzen entlangbewegt werden. Folglich ergeben sich gleichfalls die zuvor beschriebenen Nachteile.

Aufgabe der vorliegenden Erfindung ist es, ein Verfahren und eine Vorrichtung der eingangs genannten Art so auszubilden, daß möglichst reine Halbleiterschichten mit möglichst großen Kristallkörnern bei möglichst niedrigen Temperaturen abgeschieden werden, wobei das Verfahren technologisch einfach durchzuführen sein soll. Hierbei soll insbesondere sichergestellt sein, daß im Bereich der Abscheidefläche kontrollierte Temperaturbedingungen vorherrschen, so daß infolgedessen Gradienten wie Temperaturgradienten kontrolliert und reproduzierbar einstellbar sind.

Die Aufgabe wird erfindungsgemäß im wesentlichen durch ein Verfahren gelöst, das sich dadurch auszeichnet, daß die Trägerschicht über die Schmelze geführt wird und nach Verlassen der Schmelze über Gaskissen abgeführt und kontrolliert abgekühlt wird.

Erfindungsgemäß wird folglich die Trägerschicht auf der Oberfläche der Schmelze entlanggeführt. Durch ein ständiges Umpumpen und Erneuern von Schmelze sowie durch die Konvektion im Bad ist dabei gewährleistet, daß sich eine gleichmäßige Verteilung der gelösten Komponente im Bereich der Abscheidefläche einstellt. Durch das Abführen der mit dem Halbleitermaterial beschichteten Trägerschicht auf Gaskissen und das kontinuierliche Abkühlen ist des weiteren gewährleistet, daß die Halbleiterschicht weder durch mechanische Einwirkung noch durch plötzliche bzw. unstetige Temperaturänderungen nachhaltig beschädigt wird.

Vorteilhafterweise kann die Trägerschicht über zumindest ein Gaskissen der Metallschmelze zugeführt und dabei kontinuierlich erwärmt werden. Vorzugsweise setzt sich das Gaskissen aus einzelnen Gaskissenabschnitten zusammen, die unterschiedliche Temperaturen aufweisen, um so im gewünschten Umfang die Trägerschicht auf die zum Abscheiden erforderliche Temperatur aufzuwärmen bzw. anschließend kontinuierlich abzukühlen.

Nach einem weiteren Vorschlag der Erfindung ist vorgesehen, daß zum Auftragen mehrerer Schichten die Trägerschicht über mehrere Metallschmelzen unterschiedlicher Zusammensetzungen geführt wird. Dabei können die die Schmelz- aufnehmenden Behälter unmittelbar einander angrenzen, so daß ein Durchlaufverfahren realisierbar ist.

Nach einem eigenerfinderischen Vorschlag weist die Trägerschicht eine vorzugsweise im wesentlichen aus Glas oder Quarz bestehende Basisschicht auf, die aus einer Schmelze durch Erstarren auf einer Metallschmelze gebildet wird. Dabei kann aus dieser oder einer folgenden Metallschmelze eine Zwischenschicht und/oder die Halbleiterschicht aufgetragen werden. Auf die Basisschicht kann vorzugsweise Metallkarbid, Metallnitrid oder Metallborid durch Abscheiden aus einer Lösung oder PVD- oder CVD-Verfahren, Siebdruck, Plasmaspritzen oder galvanische oder naßchemische Verfahren aufgetragen werden, um die Zwischenschicht zu gewinnen. Mit anderen Worten bildet die Trägerschicht den Basiskörper für das Halbleiterschichtsystem. Dabei kann die Trägerschicht aus mehreren Schichten aufgebaut sein. Sofern die Trägerschicht ein nichtleitendes Material als Basisschicht aufweist, muß auf diese eine leitende Schicht aufgebracht werden, auf die dann die gewünschten Halbleiterschichten aufgetragen werden. Diese leitende Schicht kann als Zwischenschicht bezeichnet werden.

Vorzugsweise kann die leitende Zwischenschicht durch Abscheiden von AlB₂ aus einer Bor enthaltenden Aluminiumschmelze oder durch Abscheiden von TiAl₃ aus einer Titan enthaltenden Aluminiumschmelze hergestellt werden.

Die zur Abscheidung der Halbleiterschicht verwendete Metallschmelze enthält zumindest eines der Elemente Ag, Al, Ga, In, Cd, Pb, Sn oder Sb, wobei Si oder Ge in der Schmelze in gesättigter Lösung vorhanden sind.

Nach einem Vorschlag wird eine zumindest eines der Elemente Al, Ga oder In enthaltende Metallschmelze verwendet, in der zumindest eine binäre Verbindung wie Ga-As, Ga-P, Ga-Sb, Al-As, Al-P, Al-Sb, In-As, In-P, In-Sb gelöst werden, so daß daraus binäre oder ternäre Verbindungshalbleiter-Schichten wie GaAs, GaP, Ga₁₋ₓAlₓAs, GaAs₁₋ₓPx etc. abgeschieden werden können.

Sofern das Abscheiden durch einen Temperaturgradienten zwischen Schmelze und Trägerschicht erfolgt, wird dieser vorzugsweise durch Wärmeabstrahlung und/oder Gaskühlung erzeugt.

Unabhängig davon wird bei dem erfindungsgemäßen Verfahren vorzugsweise eine Temperaturdifferenz ΔT zwischen der Abscheiderfläche und der Metallschmelze zwischen 1°C und 100°C eingestellt.

Eine Vorrichtung zur Herstellung eines Halbleiter-Schichtsystems für insbesondere großflächige photovoltaische Bauelemente, wobei zumindest eine Halbleiterschicht auf eine Trägerschicht dadurch auftragbar ist, daß die Trägerschicht mit einer gelöstes Halbleitermaterial mit gegebenenfalls gewünschten Dotierstoffen aufweisender Metallschmelze in Berührung bringbar ist und daß durch Erzeugung eines Gradienten wie Temperaturgradienten zwischen der Schmelze und der Trägerschicht das Halbleitermaterial mit den gegebenenfalls vorhandenen Dotierstoffen auf der Trägerschicht abscheidbar ist, zeichnet sich dadurch aus, daß die Vorrichtung zumindest einen Reaktionsraum umfaßt, dessen bodenseitiger Bereich mit der Metallschmelze gefüllt ist und in dessen deckenseitigem Bereich Heizelemente zur kontrollierten Temperatureinstellung der Trägerschicht angeordnet sind, und daß zumindest dem Reaktionsraum Einrichtungen zur Erzeugung eines Gaskissens zum Transport der Trägerschicht mit auf dieser abgeschiedenen Halbleiterschicht nachgeordnet sind.

Vorzugsweise sind mehrere Reaktionsräume hintereinander angeordnet, wobei die Oberflächen der Metallschmelze auf unterschiedlichem Niveaux einstellbar sind.

Die Trägerschicht kann gegebenenfalls über mehrere Gaskissen dem bzw. den Reaktionsräumen zu und/oder von diesem bzw. diesen weggeführt werden, wobei zur kontinuierlichen Aufheizung bzw. Abkühlung die Gaskissenabschnitte unterschiedliche Temperaturen aufweisen können. Ferner sind oberhalb des Transportweges der Trägerschicht Heizelemente angeordnet, um die Temperatur kontrolliert einstellen zu können.

Jeder Reaktionsraum ist ferner mit Umwälzeinrichtungen versehen, durch die zum einen die Temperatur der Metallschmelze mit gelöstem Halbleitermaterial bzw. Dotierstoffe stets auf die gewünschte Temperatur einstellbar ist, wobei gleichzeitig Schmelze in einem Umfang zugeführt wird, der der Abscheiderrate auf der Trägerschicht entspricht.

Schließlich ist nach einer weiteren Ausgestaltung vorgesehen, daß dem ersten Reaktionsbehälter ein Glasschmelze enthaltender Schmelzofen vorgeschaltet ist, von der die Schmelze im zähflüssigen Zustand auf die Metallschmelze des sich anschließenden Reaktionsraumes in kontrollierter Dicke verteilt wird, um zum einen ein Erstarren der Glasschmelze und zum anderen ein Abscheiden eines z.B. metallischen Rückkontaktes (Zwischenschicht) zu ermöglichen. Von diesem Reaktionsraum gelangt die Trägerschicht in Form des Glassubstrats mit aufgebrachter Metallschicht in einen weiteren Reaktionsraum, in der eine gegebenenfalls dotierte erste Halbleiterschicht abgeschieden wird, um vorzugsweise in einem nachfolgenden Reaktionsraum eine zweite Halbleiterschicht anderer Dotierung aufzutragen. Anschließend gelangt das auf diese Weise hergestellte Schichtsystem über vorzugsweise Gaskissen in eine Abkühlzone, um die definierte Abkühlung von Schicht und Substrat zu ermöglichen. Um sodann ein fertiges Schichtsystem für insbesondere eine photovoltaische Zelle zur Verfügung zu stellen, werden auf die außenliegende Halbleiterschicht ein elektrisch leitender Frontkontakt und gegebenenfalls weitere Schichten wie Antireflexionsschicht und eine Verkapselung in Form einer Abdeckplatte aufgebracht.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden bevorzugten Ausführungsbeispielen.

Es zeigen:
- Fig. 1: eine Prinzipdarstellung einer Vorrichtung zum Auftragen einer Halbleiterschicht auf einer Trägerschicht,
- Fig. 2: eine Abwandlung der Vorrichtung nach Fig. 1 und
- Fig. 3: eine Vorrichtung zur Herstellung einer pn-Halbleiterschicht.

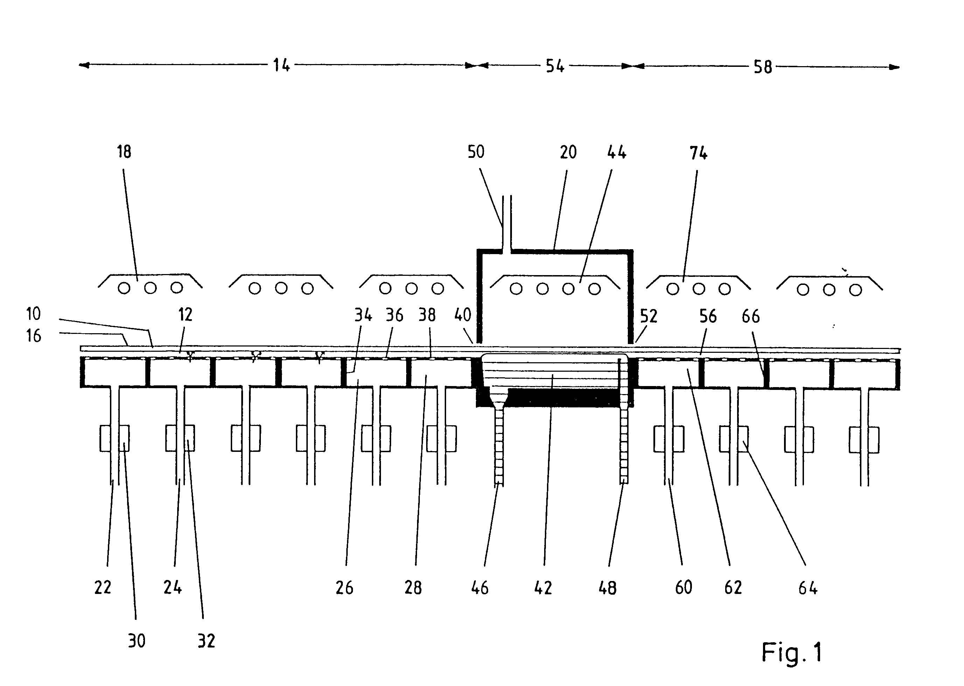

In Fig. 1 ist mit dem Bezugszeichen (10) eine Trägerschicht in Form eines selbsttragenden Substrats bezeichnet, das mit einer nicht näher in der Zeichnung gekennzeichneten Zwischenschicht in Form einer einen elektrisch leitenden Kontakt bildenden Schicht und gegebenenfalls einer auf dieser vorhandenen Diffusions-Barrierenschicht ausgebildet sein kann. Das Substrat (10) wird zunächst auf Gaskissen (12) durch eine Strecke (14) geführt, in der eine Vorbehandlung erfolgt. Dabei ist die Unterschicht dem Gaskissen (12) zugewandt. Auf der Rückseite (16) des Substrats (10) sind Heizeinrichtungen (18) entlang der Transportstrecke (14) angeordnet, um eine kontinuierliche Erwärmung in einem Umfang zu ermöglichen, daß das nach der Strecke (14) einem Reaktionsraum (20) zugeführte Substrat in nachstehend beschriebener Weise mit einer Halbleiterschicht gegebenenfalls gewünschter Dotierung beschichtet wird. Die Aufheizung kann dabei von z.B. 25° auf z.B. 950° dann erfolgen, wenn Silizium abgeschieden werden soll. Zusätzlich erfolgt eine Vorbehandlung des Substrats (10) und der Unterschicht dadurch, daß entlang des Transportweges (14) eine Temperung in einer Schutzgasatmosphäre erfolgt. Letztere wird durch die Gaskissen (12) bewirkt.

Das Schutzgas wird über Leitungen Kammern zugeführt, die nebeneinander angeordnet sind und eine Längenerstreckung aufweisen, die der mit dem Bezugszeichen (14) entspricht. Beispielhaft sind Zuleitungen mit den Bezugszeichen (22) und (24) und Luftkammern mit den Bezugszeichen (26) und (28) bezeichnet. Zuleitungen und Kammern können gleich ausgebildet werden. Dabei sind die einzelnen Kammern durch Wände (siehe beispielsweise Bezugszeichen (34)) getrennt.

In den Zuleitungen (22) und (24) sind Heizeinrichtungen wie Heizmanschetten (30), (32) angeordnet, um das Schutzgas auf die gewünschte Temperatur zu erwärmen. Substratseitig weisen die Kammern (26) und (28) Austrittsdüsen (36), (38) auf.

Sind im Ausführungsbeispiel die Kammern (26), (28) durch Trennwände (34) getrennt, so kann selbstverständlich auch eine einzige sich entlang der Strecke (14) erstreckende Gaskammer vorgesehen sein, um so das erforderliche Luftkissen zum Transport des Substrats zur Verfügung zu stellen.

Nachdem das Substrat (10) auf eine gewünschte Temperatur erwärmt ist, gelangt es über einen Schlitz (40) in den Reaktionsraum (20), in dem aus einer Metallschmelze (42) auf der Unterseite des Substrats (10), also auf der nicht näher bezeichneten Unterschicht eine weitere Schicht abgeschieden werden soll. Unterhalb des Schlitzes (40), also im Bodenbereich des Reaktionsbehälters (20) befindet sich die Schmelze (42), in der Halbleitermaterial gelöst ist. Die Schmelze kann z.B. aus Sn bestehen, in der Si bei 950°C gesättigt gelöst ist. Wird das Substrat (10) auf der Oberfläche der Schmelze (42) vorzugsweise unter einem leicht geneigten Winkel zu dieser geführt und die Temperatur des Substrats (10) kälter als die der Schmelze (42) eingestellt, so erfolgt an der freien Oberfläche der Zwischenschicht eine Unterkühlung der Schmelze und damit Übersättigung des Halbleitermaterials, das folglich auf der Zwischenschicht abgeschieden wird. Die gewünschte Temperatureinstellung des Substrats (10) und damit der freien Oberfläche der Zwischenschicht erfolgt über Heizeinrichtungen (44), die deckenseitig im Reaktionsbehälter (20) angeordnet sind. Die Metallschmelze (42) wird über eine Einlaßöffnung (46) dem Reaktionsbehälter (20) zu- und über eine Auslaßöffnung (48) abgeführt. Zur Aufrechterhaltung einer konstanten Zusammensetzung des Schmelzbades (42) wird Schmelzmaterial ständig umgepumpt und erneuert. Darüber hinaus wirkt die Konvektion in dem Schmelzbad für eine gleichmäßige Verteilung der gelösten Komponenten.

Über eine vorzugsweise deckenseitig angeordnete Zuleitung (50) kann ein Inertgas wie z.B. Ar in den Reaktionsbehälter (20) eingeleitet werden. Ein Austritt erfolgt über den Einantrittsschlitz (40) und den gegenüberliegenden Austrittschlitz (52), durch den das beschichtete Substrat (10) aus der Reaktionskammer (20) herausgeführt wird.

Die Transportgeschwindigkeit des Substrats (10) wird so eingestellt, daß sich eine Halbleiterschicht der Größenordnung von 0,1µm bis 200µm beim Durchqueren des Reaktionsraumes (20), also während des Transports entlang der Strecke (54) abscheidet.

Nach Verlassen des Reaktionsbehälters (20) wird an dem Substrat (10) vorhandene Schmelze entfernt, das anschließend über Gaskissen (56) entlang einer Abkühlstrecke (58) geführt wird, um die gewünschte kontinuierliche Abkühlung der abgeschiedenen Schicht bzw. Schichten zu gewährleisten. Die Gaskissen werden dabei entsprechend der Anordnung entlang der Strecke (14) durch über Leitungen (60) und Gaskammern (62) zugeführtes Schutzgas erzeugt, das über Heizeinrichtungen (64) wie Heizmanschetten im gewünschten Umfang in der Temperatur graduell abgestuft eingestellt werden kann. Die einzelnen Kammern (62) sind durch Trennwände (66) unterteilt.

Die Temperatur der Metallschmelze (42) liegt zwischen der Schmelztemperatur des Reinmetalls bzw. der Schmelztemperatur des der abzuscheidenden Halbleiterverbindung nahegelegenen Eutektikums und der Schmelztemperatur des Halbleiters selbst. Sofern in einer Sn-Schmelze Silizium (Schmelztemperatur 1410°C) gelöst wird, ist zur Abscheidung einer Halbleiterschicht eine Temperatur zwischen 900°C und 1000°C geeignet. Bei dieser Zusammensetzung befinden sich ca. 5 bis 6at% Si in der Sn-Schmelze.

Zur Abscheidung der Si-Schichten auf dem Substrat (10) sind insbesondere binäre Lösungen mit den Elementen Ag, Al, Cd, Ga, In, Pb, Sb oder Sn geeignet. Dieselben Elemente bilden auch Lösungen mit Germanium. Dadurch lassen sich auch Ge-Schichten und Si-Ge-Mischkristall-Schichten abscheiden, letztere dann, wenn man Si und Ge im geeigneten Verhältnis zu dem Lösungsmittel zugibt. Auch Mischungen aus den genannten Metall-Schmelzungen können als Lösungsmittel in Frage kommen. Die Löslichkeit der oben genannten Metalle in Si bzw. Ge ist so gering, daß sich sehr reine Schichten herstellen lassen.

Als Substrate selbst können Quarz, Glas, Keramik, Graphit, metallurgisches Silizium und Metallfolien oder Metallplatten (z.B. aus Edelstahl) verwendet werden.

Durch die erfindungsgemäße Lehre ergibt sich u.a. auch der Vorteil, daß selbst Glassubstrate, deren Erweichungstemperatur niedrig liegt, zum Einsatz gelangen können, da diese auf der Schmelze schwimmen. In diesem Fall wird das Substrat von der Lösung getragen. Gleichzeitig erfolgt eine Beschichtung des Glases.

Damit Metallschmelzen Glas oder Quarz benetzen können, wird eine Benetzungsschicht durch Lösungswachstum, Aufdampfen, Sputtern, CVD-Verfahren, Tauchverfahren oder Plasmaspritztechnik auf das Substrat aufgebracht.

Hinsichtlich der angesprochenen Zwischenschicht ist zu bemerken, daß sie zum einen die Aufgabe einer Benetzungsschicht und zum anderen die Funktion einer Diffusionssperre ausüben kann und/oder als leitender Rückkontakt einer Solarzelle dient. Als Materialien für die Zwischenschicht sind Metalle oder Metallegierungen aus Kohlenstoff, Metallboriden, Metallcarbiden, Metallnitriden oder Metallsiliciden geeignet. Entsprechende Schichten können einen spezifischen Widerstand kleiner als 10⁻³ Ω cm aufweisen, so daß sie erwähntermaßen als Rückkontakt geeignet sind.

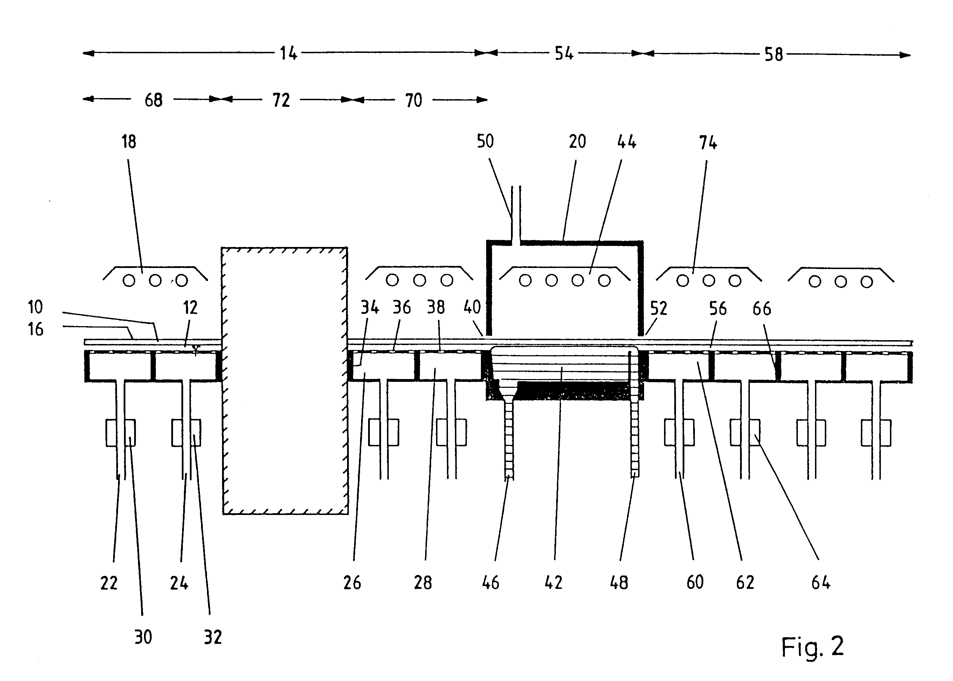

Die Zwischenschicht selbst kann in einer gesonderten Beschichtungsanlage auf das Substrat (10) aufgetragen werden. Gemäß Fig. 2, ist jedoch auch die Möglichkeit gegeben, das Substrat (10) im Bereich der Vorbehandlungsstrecke (14) zu behandeln. Die der Fig. 2 zu entnehmende Beschichtungsanlage entspricht der der Fig. 1, so daß gleiche Elemente mit gleichen Bezugszeichen versehen sind. In die in die Abschnitte (68) und (70) unterteilte Vorbehandlungsstrecke (14) ist eine Behandlungseinrichtung (72) integriert, in der die Zwischenschicht z.B. mittels PVD-, CVD-Verfahren, Siebdruck, Plasmaspritzen oder galvanischer oder naßchemischer Abscheidung auf das Substrat (10) aufgebracht werden kann. Durch diese Einfügung ist weiterhin ein kontinuierlicher Beschichtungsvorgang möglich, so daß hohe Durchsätze realisierbar sind.

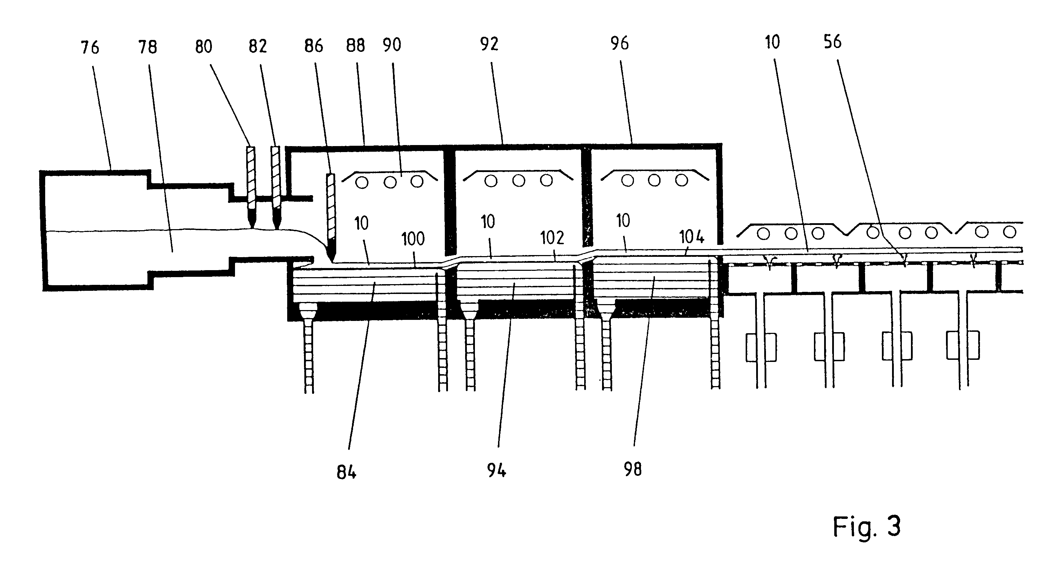

Eine hervorzuhebende Ausführungsform der Erfindung ist in der Fig. 3 dargestellt, in der zum einen die Trägerschicht, also das selbsttragende Substrat aus einer Schmelze und sodann ein Abscheiden gewünschter Schichten realisierbar ist.

In einem Schmelzofen (76) wird Glas aufgeschmolzen. Die gewonnene Glasschmelze (78) wird über höhenmäßig einstellbare Schieberelemente (80), (82) einer Metallschmelze (84) zugeführt, auf der die Glasschmelze schwimmend erstarrt. Die Dicke der Trägerschicht bzw. des Substrats (10) wird durch ein weiteres Schieber- bzw. Abstreifelement (86) eingestellt. Die Schmelze (84) befindet sich dabei in einem ersten Reaktionsbehälter (88), der deckenseitig Heizelemente (90) zur Einstellung der gewünschten Temperatur der Glasschmelze bzw. des Glassubstrats (10) besetzt. Aus der Schmelze (84), bei der es sich um eine Al-Schmelze handelt, kann eine AlB₂-Schicht oder eine Metall-Schicht TiAl₃ als Rückkontakt und Benetzungsschicht abgeschieden werden. Das Substrat (10) wird sodann während des Abscheidens der gewünschten Schichten auf der Oberfläche der Schmelze (84) weitertransportiert, um einem zweiten Reaktionsbehälter (92) zugeführt zu werden, in der sich eine Schmelze (94) wie z.B. Si-Sn-Lösung mit p-Dotierung befinden kann. In dem Reaktionsbehälter (92) wird auf das Substrat (10) mit den der Schmelze (94) zugewandten Schichten eine p-dotierte Siliziumschicht abgeschieden. Sodann gelangt das so gewonnene Schichtsystem in einen dritten Reaktionsbehälter (96), um aus einer weiteren Metallschmelze (98), bei der es sich um eine mit Phosphor dotierte Si-Sn-Lösung handeln kann, eine n-leitende zweite Si-Halbleiterschicht abzuscheiden. Nach Verlassen des Reaktionsbehälters (96) wird entsprechend der Fig. 1 und 2 das Substrat mit den gewünschten Schichten über das Gaskissen (56) wegtransportiert, wobei die gewünschte kontinuierliche Abkühlung erfolgt.

Wie die Fig. 3 verdeutlicht, sind die Oberflächen (100), (102) und (104) der Schmelzen (84), (94), (98) auf unterschiedlichem Niveau angeordnet. Dabei ist das Niveau von der ersten Reaktionskammer (88) zur letzten Reaktionskammer (96) ansteigend ausgebildet. Ein stufenförmiger Übergang von Schmelze zu Schmelze ist hierdurch gegeben, der einer Verschleppung von Material entgegenwirkt.

## Patentansprüche

1. Verfahren zur Herstellung eines Halbleiter-Schichtsystems für insbesondere großflächige photovoltaische Bauelemente, wobei zumindest eine Halbleiterschicht auf einer Trägerschicht dadurch aufgetragen wird, daß die Trägerschicht mit einer gelöstes Halbleitermaterial mit gegebenenfalls gewünschten Dotierstoffen enthaltenden Metallschmelze in Berührung gebracht wird und daß durch Erzeugung eines Temperaturgradienten zwischen der Schmelz- und der Trägerschicht das Halbleitermaterial mit den gegebenenfalls vorhandenen Dotierstoffen auf der Trägerschicht abgeschieden wird,
**dadurch gekennzeichnet**,
daß die Trägerschicht (10) über die Schmelze (42, 84, 94, 98) geführt wird und nach Verlassen der Schmelze über Gaskissen (56) abgeführt und kontrolliert abgekühlt wird.

2. Verfahren nach Anspruch 1,
**dadurch gekennzeichnet**,
daß die Trägerschicht (10) über Gaskissen (12) der Metallschmelze (42, 84, 94, 98) zugeführt und kontinuierlich auf die zum Aufbringen des Halbleitermaterials notwendige Temperatur erwärmt wird.

3. Verfahren nach Anspruch 1,
**dadurch gekennzeichnet**,
daß zum Auftragen mehrerer Schichten die Trägerschicht (10) über mehrere Metallschmelzen (84, 94, 98) unterschiedlicher Zusammensetzung geführt wird.

4. Verfahren nach Anspruch 1,
**dadurch gekennzeichnet**,
daß die Trägerschicht (10) und die gegebenenfalls aufgebrachte Halbleiterschicht über mehrere unterschiedliche Temperaturen aufweisende Gaskissen (12, 56) zu- und/oder abgeführt werden.

5. Verfahren nach Anspruch 1,
**dadurch gekennzeichnet**,
daß die Trägerschicht (10) eine vorzugsweise im wesentlichen aus Glas oder Quarz bestehende Basisschicht umfaßt, die aus einer Schmelze (78) durch Erstarren auf einer Metallschmelze (84) gebildet wird, wobei aus der oder einer folgenden Metallschmelze (94, 98) eine Zwischenschicht und/oder die Halbleiterschicht aufgetragen wird.

6. Verfahren nach Anspruch 1,
**dadurch gekennzeichnet**,
daß die verwendete Metallschmelze (47, 84, 94, 98) zumindest eines der Elemente Ag, Al, Ca, In, Cd, Pb, Sn oder Sb und zur Abscheidung der Halbleiterschicht Si und/oder Ge in Lösung enthält.

7. Verfahren nach Anspruch 1,
**dadurch gekennzeichnet**,
daß eine zumindest eines der Elemente Al, Ga oder In enthaltende Metallschmelze (42, 84, 94, 98) verwendet wird, in der zumindest eine binäre Verbindung wie GaAs, GaP, GaSb, AlAs, AlP, AlSb, InAs, InP, InSb gelöst wird.

8. Verfahren nach Anspruch 1,
**dadurch gekennzeichnet**,
daß Glas, Keramik oder Metall als Basisschicht der Trägerschicht (10) verwendet wird.

9. Verfahren nach Anspruch 8,
**dadurch gekennzeichnet**,
daß auf der Basisschicht vorzugsweise Metallkarbid, Metallnitrid oder Metallborid durch Abscheiden aus einer Lösung oder durch ein PVD-, CVD-, galvanisches oder naßchemisches Verfahren oder durch Siebdruck oder Plasmaspritzen aufgetragen wird.

10. Verfahren nach Anspruch 1,
**dadurch gekennzeichnet**,
daß der Temperaturgradient zwischen der Metallschmelze (42, 84, 94, 98) und der freien Oberfläche (Abscheidefläche) der Trägerschicht (10) durch Gaskühlung und/oder Wärmestrahler erzeugt wird.

11. Verfahren nach Anspruch 10,
**dadurch gekennzeichnet**,
daß die Temperaturdifferenz Δ T zwischen der Abscheidefläche und der Metallschmelze (42, 84, 94, 98) auf 1°C <ΔT< 100°C eingestellt wird.

12. Vorrichtung zur Herstellung eines Halbleiter-Schichtsystems für insbesondere großflächige photovoltaische Bauelemente, wobei zumindest eine Halbleiterschicht auf eine Trägerschicht dadurch auftragbar ist, daß die Trägerschicht mit einer gelöstes Halbleitermaterial mit gegebenenfalls gewünschten Dotierstoffen aufweisenden Metallschmelze in Berührung bringbar ist und daß durch Erzeugung eines Temperaturgradienten zwischen der Schmelze und der Trägerschicht das Halbleitermaterial mit den gegebenenfalls vorhandenen Dotierstoffen auf der Trägerschicht abscheidbar ist,
**dadurch gekennzeichnet**,
daß die Vorrichtung zumindest einen Reaktionsraum (20, 88, 92, 96) umfaßt, dessen bodenseitiger Bereich mit der Metallschmelze (42, 84, 94, 98) gefüllt ist und in dessen deckenseitigem Bereich Heizelemente zur kontrollierten Temperatureinstellung der Trägerschicht (10) angeordnet sind und daß dem Reaktionsraum Einrichtungen zur Erzeugung von Gaskissen (12, 56) zum Transport der Trägerschicht vorgeschaltet und/oder nachgeordnet sind.

13. Vorrichtung nach Anspruch 12,
**dadurch gekennzeichnet**,
daß mehrere Reaktionsräume (88, 92, 96) hintereinander angeordnet sind, wobei die Oberflächen (100, 102, 104) der Metallschmelzen (84, 94, 98) auf unterschiedlichen Niveaux einstellbar sind.

14. Vorrichtung nach Anspruch 12,
**dadurch gekennzeichnet**,
daß dem ersten Reaktionsraum (18) ein Schmelzofen (76) vorgeschaltet ist, über den eine Glasschmelze (78) auf die Metallschmelze (84) des ersten Reaktionsraumes (48) abgebbar ist.

## Claims

1. Method for producing a layered system of semiconductors more particularly for large-area photovoltaic components, with at least one semiconductor layer being applied to a carrier layer such that the carrier layer is brought in contact with a metal melt, said metal melt containing dissolved semiconductor material and said material containing any desired doping substances, and such that, through producing a temperature gradient between the melt and the carrier layer, the semiconductor material containing any existing doping substances is deposited on the carrier layer,
**characterized in that**
said carrier layer (10) is passed over said melt (42, 84, 94, 98) and, upon leaving the melt, is carried off on gas cushions (56) and cooled in a controled manner.

2. Method according to claim 1,
**characterized in that**
said carrier layer (10) is passed over gas cushions (12) upstream of said metal melt (42, 84, 94, 98) and continuously heated to a temperature needed for deposition of the semiconductor material.

3. Method according to claim 1,
**characterized in that**
said carrier layer (10) is moved over several melts (84, 94, 98) of different composition so as to deposit several layers.

4. Method according to claim 1,
**characterized in that**
said carrier layer (10) and the semiconductor layer that may have been laid on are passed upstream and downstream over several gas cushions (12, 56), said cushions being at different temperatures.

5. Method according to claim 1,
**characterized in that**
said carrier layer (10) preferably has a basic layer substantially consisting of glass or quartz, said basic layer being formed from melt (78) by solidification on a metal melt (84), with an intermediate layer and/or the semiconductor layer being deposited from said metal melt or one of the subsequent metal melts (94, 98).

6. Method according to claim 1,
**characterized in that**
said used metal melt (47, 84, 94, 98) contains at least one of the elements Ag, Al, Ga, In, Cd, Pb, Sn, or Sb, and for deposition of the semiconductor layer said used metal melt contains Si and/or Ga in solution.

7. Method according to claim 1,
**characterized in that**
a metal melt (42, 84, 94, 98) is used which contains at least one of the elements Al, Ga, or In, with at least one binary compound such as GaAs, GaP, GaSb, AlAs, AlP, AlSb, InAs, InP, InSb being dissolved in said metal melt.

8. Method according to claim 1,
**characterized in that**
glass, ceramics, or metal is used as a basic layer of said carrier layer (10).

9. Method according to claim 8,
**characterized in that**
preferably metallic carbide, metallic nitride, or metallic boride is applied to a basic layer by segregation from a solution or by a PVD or CVD technique, by screen printing, plasma injection, or galvanic or wet chemical techniques.

10. Method according to claim 8,
**characterized in that**
the temperature gradient between said metal melt (42, 84, 94, 98) and the free surface (deposition area) of said carrier layer (10) is produced by gas cooling and/or thermal radiation.

11. Method according to claim 10,
**characterized in that**
the temperature difference ΔT between the deposition area and the metal melt (42, 84, 94, 98) is set at 1° C < ΔT < 100° C.

12. Device for producing a layered semiconductor system more particularly for large-surfaced photovoltaic components, with at least one semiconductor layer being depositable on a carrier layer in that the carrier layer can be brought into contact with a metal melt, said metal melt containing dissolved semiconductor material and said material containing any desired doping substances, and such that, through producing a temperature gradient between the melt and the carrier layer, the semiconductor material containing any existing doping substances can be deposited on the carrier layer,
**characterized in that**
said device comprises at least one reaction vessel (20, 88, 92, 96) whose bottom portion is filled with metal melt (42, 84, 94, 98) and in whose top portion heating elements are disposed to allow the temperature of said carrier layer (10) to be adjusted in a controlled manner, and that means for producing gas cushions (12, 56) used for the transport of the carrier layer are arranged upstream and/or downstream of the reaction vessel.

13. Means according to claim 12,
**characterized in that**
several reaction vessels (88, 92, 96) are arranged in series, with surfaces (100, 102, 104) of metal melts (84, 94, 98) being adjustable at different levels.

14. Means according to claim 12,
**characterized in that**
a melting furnace (76) is arranged upstream of the first reaction vessel (18), said furnace being used to apply a glass melt (78) to metal melt (84) of the first reaction vessel (48).

## Revendications

1. Procédé de fabrication d'un système à couche semi-conductrice notamment pour des composants photovoltaïques de grande surface, dans lequel on dépose au moins une couche de semi-conducteur sur une couche support, en mettant en contact la couche support avec une masse de métal fondu contenant du matériau semi-conducteur dissous avec le cas échéant des éléments de dopage souhaités et en provoquant un gradient de température entre la couche fondue et la couche support, on dépose le matériau semi-conducteur avec les éléments de dopage présents le cas échéant sur la couche support,
caractérisé en ce qu'on conduit la couche support (10) sur la masse fondue (42, 84, 94, 98) et qu'après la masse fondue, elle est transférée sur coussin de gaz (56) et est refroidie de manière maîtrisée.

2. Procédé salon la revendication 1, caractérisé en ce qu'on apporte la couche support (10) sur coussin de gaz (12) à la masse de métal fondue (42, 84, 94, 98) et qu'on la réchauffe à la température nécessaire au dépôt de matériau semi-conducteur.

3. Procédé selon la revendication 1, caractérisé en ce que pour déposer plusieurs couches, on fait passer la couche support (10) sur plusieurs masses fondues de métal (84, 94, 98) de compositions différentes.

4. Procédé selon la revendication 1, caractérisé en ce que la couche support (10) et la couche de semi-conducteur, déposée le cas échéant sont apportées et/ou retirées sur plusieurs coussins de gaz (12, 56) présentant des températures différentes.

5. Procédé selon la revendication 1, caractérisé en ce que la couche support (10) comprend une couche de base constituée essentiellement de préférence de verre ou de quartz qui est formée à partir d'une masse fondue (78) par solidification sur une masse fondue de métal (84), en déposant une couche intermédiaire et/ou la couche de semi-conducteur sur la ou une masse fondue métallique suivante (94, 98).

6. Procédé selon la revendication 1, caractérisé en ce que la masse fondue métallique utilisée (47, 84, 94, 98) contient au moins l'un des éléments Ag, Al, Ga, In, Cd, Pb, Sn ou Sb et contient en solution Si ou Sb pour former la couche de semi-conducteur par séparation.

7. Procédé selon la revendication 1, caractérisé en ce qu'on utilise une masse métallique fondue (42, 84, 94, 98) contenant au moins l'un des éléments Al, Ga ou In, dans laquelle au moins un composé binaire tel que GaAs, GaP, GaSb, AlAs, AlP, AlSb, InAs, InP, InSb est dissous.

8. Procédé selon la revendication 1, caractérisé en ce qu'on utilise du verre, de la céramique ou du métal comme couche de base de la couche support (10).

9. Procédé selon la revendication 8, caractérisé en ce qu'on dépose sur la couche de base de préférence du carbure métallique, du nitrure métallique ou du borure métallique par séparation à partir d'une solution ou par un procédé PVD, CVD, galvanique ou chimique humide ou par sérigraphie ou par pulvérisation par plasma.

10. Procédé selon la revendication 1, caractérisé en ce qu'on réalise le gradient de température entre la masse métallique fondue (42, 84, 94, 98) et la surface libre (surface de séparation) de la couche support (10) par refroidissement par gaz et/ou par radiation thermique.

11. Procédé selon la revendication 10, caractérisé en ce qu'on ajuste l'écart de température ΔT entre la surface de séparation et la masse métallique fondue (42, 84, 94, 98) à 1°C < ΔT < 100°C.

12. Dispositif de fabrication d'un système à couche semi-conductrice notamment pour des composants photovoltaïques de grande surface, dans lequel on peut déposer au moins une couche de semi-conducteur sur une couche support, en mettant en contact la couche support avec une masse de métal fondu contenant du matériau semi-conducteur dissous avec le cas échéant des éléments de dopage souhaités et en provoquant un gradient de température entre la couche fondue et la couche support, on peut déposer le matériau semi-conducteur avec les éléments de dopage présents le cas échéant sur la couche support, caractérisé en ce que le dispositif comprend au moins une chambre de réaction (20, 88, 92, 96) dont la zone de fond est remplie de masse métallique fondue (42, 84, 94, 98) et des éléments chauffants sont placés dans la zone de plafond pour ajuster la température contrôlée (10) et qu'on implante en amont et/ou disposé après la chambre de réaction on implante des dispositifs de production de coussin de gaz (12, 56) pour le transfert de la couche support.

13. Dispositif selon la revendication 12, caractérisé en ce qu'on dispose plusieurs chambres de réaction (88, 92, 96) l'une derrière l'autre, les surfaces (100, 102, 104) des masses métalliques fondues (84, 94, 98) étant réglables à des niveaux différents.

14. Dispositif selon la revendication 12, caractérisé en ce qu'on place en amont de la première chambre de réaction (18) un four de fusion (76), grâce auquel on peut introduire une masse de verre fondue (78) sur la masse métallique fondue (84) de la première chambre de réaction (48).
